# FASCICULE DE BREVET EUROPEEN

(11) **EP 1 420 468 B1**
(45) Date de publication et mention de la délivrance du brevet: **26.01.2011**
(21) Numéro de dépôt: 03292748.5
(22) Date de dépôt: 04.11.2003
(51) Int. Cl.: H01L 41/06, F02D 41/20

(54) **Dispositif d'actionnement muni d'une topologie électronique de pilotage**
Aktuator mit elektronischer Steuerung
Actuator with electronic control

(30) Priorité: 04.11.2002 FR 0213762
(43) Date de publication de la demande: 19.05.2004
(73) Titulaire: Renault s.a.s., 92100 Boulogne-Billancourt (FR)
(72) Inventeur: Ripoll, Christophe, 78220 Viroflay (FR); Levin, Laurent, 75015 Paris (FR)
(74) Mandataire: Cémeli, Eric Philippe Laurent

(56) Documents cités:
- WO-A1-00/45403
- WO-A1-01/52294
- DE-A1- 4 413 240
- DE-A1- 10 020 896
- DE-A1- 19 747 033
- DE-A1- 19 936 945
- FR-A1- 2 739 217
- US-A- 4 453 652
- US-A- 4 642 725
- US-B1- 6 364 221

## Description

L'invention concerne le pilotage des actionneurs, et en particulier un dispositif d'actionnement muni d'une topologie électronique de pilotage d'un actionneur.

Des actionneurs piézostrictifs ou magnétostrictifs sont notamment utilisés dans des injecteurs de carburant pour moteurs de véhicules.

Les injecteurs automobiles ont connu des développements importants ces dernières années. Des développements ont notamment été réalisés sur l'injection directe essence ou diesel, les moteurs à rampe commune haute pression ou encore les injecteurs pompe.

Les injecteurs utilisent classiquement une pompe électrique d'alimentation en carburant. Dans le cas d'un moteur Diesel à rampe commune, la pompe alimente un canal d'une rampe de distribution de l'ensemble des injecteurs sous une pression de source sensiblement constante, de l'ordre de 1600 bars par exemple. Le canal communique avec des conduites obturées par un injecteur respectif. L'ouverture d'une vanne de l'injecteur provoque l'injection, par exemple dans la chambre de combustion en cas d'injection directe.

La vanne comprend classiquement une aiguille obturant sélectivement une buse d'injection en fonction de commandes qui lui sont appliquées. L'aiguille est classiquement déplacée entre une position de consigne d'injection et une position de consigne d'obturation. Le déplacement de l'aiguille est habituellement généré par un actionneur magnétostrictif ou un actionneur piézostrictif.

Afin d'accroître la quantité de carburant injectée, il est connu d'augmenter la durée d'injection. Cette durée est cependant limitée par des contraintes sur les conditions d'injection. Le carburant est le plus souvent injecté à partir du point mort haut du piston correspondant, et le temps d'injection durant la phase de détente doit être limité.

La quantité de carburant injectée peut également être augmentée par augmentation de la pression d'injection. Une telle augmentation de pression implique des prix prohibitifs des éléments du dispositif d'injection.

La quantité de carburant peut également être augmentée en utilisant une buse d'injection de taille accrue. Une telle buse détériore la qualité de la pulvérisation du carburant. Le carburant injecté tend alors à se déposer sur les parois du conduit d'admission ou de la chambre de combustion. Ceci implique des prestations de dépollution détériorées, notamment car la quantité instantanée réelle de carburant rentrant dans la chambre de combustion est mal connue. Ce phénomène est notamment à l'origine de la majeure partie des émissions de polluants lors d'un démarrage à froid du moteur.

Par ailleurs, l'aiguille présente le plus souvent une extrémité d'obturation conique, venant reposer sur un siège de la buse pour garantir l'obturation. A l'initiation de l'injection, l'aiguille quitte le siège, et le carburant est temporairement injecté en formant un bulbe. Le débit instantané de l'injecteur n'est ainsi pas contrôlé précisément.

Ces divers problèmes conduisent globalement à une vaporisation incomplète et non homogène du carburant lors de la formation du mélange dans la chambre de combustion, et à un contrôle imprécis de la richesse du mélange. Les conséquences sont donc une altération du rendement du moteur et la formation d'une quantité élevée de gaz polluants.

Par ailleurs, les dispositifs d'injection, présentant une pompe alimentant une rampe d'accumulation de carburant telle qu'une rampe commune, présentent d'autres inconvénients. Lors de la transition entre la fermeture et l'ouverture de l'aiguille d'injecteur, la pompe n'alimente généralement pas la rampe. Ainsi, lors de l'ouverture de l'aiguille, la pression de carburant injectée instantanée dépasse parfois la pression de consigne. Cela génère notamment un bruit de fonctionnement excessif.

Le document FR-A-2 801 346 décrit un dispositif d'injection comprenant une vanne munie d'une aiguille d'obturation déplacée par un actionneur piézoélectrique. A l'initiation d'une injection, l'extrémité de l'aiguille est décollée du siège de la buse, puis déplacée jusqu'à une position d'injection de consigne par l'actionneur piézoélectrique. L'actionneur piézoélectrique comprend une commande générant des oscillations mécaniques de l'actionneur, transmises à l'aiguille en oscillations par rapport à la position d'ouverture de consigne.

Le document EP-A-1 031 721 décrit un procédé d'injection traitant ce problème. Une aiguille d'un injecteur, mettant sélectivement en communication une rampe d'alimentation en carburant et un réservoir de carburant, est ouverte en dehors des phases d'injection vers une chambre à combustion interne. La pression dans la rampe est ainsi réduite à une valeur de consigne en évacuant du carburant contenu dans la rampe. La pression de consigne est donc respectée lors de l'injection du carburant dans la chambre de combustion.

Un injecteur automobile muni d'un actionneur magnétostrictif et d'une commande de pilotage de cet actionneur est connu de l'état de la technique. La topologie électronique de pilotage de l'actionneur présente une source de tension continue. L'impédance d'entrée de l'actionneur est montée en pont entre quatre interrupteurs Mos. Le pont est alimenté par la source de tension continue. La commande comprend également un dispositif de pilotage de la topologie électronique. Le dispositif de pilotage commande les ouvertures ou fermetures des interrupteurs, afin de générer un déplacement de l'actionneur suivant une course jusqu'à une position de consigne, puis générer un déplacement alternatif de moindre amplitude autour de la position de consigne.

Cette commande présente des inconvénients. Cette commande implique une topologie électronique de pilotage relativement complexe et implique également un dispositif de pilotage de la topologie à la fois complexe et coûteux. Il existe donc un besoin pour un dispositif d'actionnement muni d'une topologie électronique de pilotage qui résolve un ou plusieurs de ces inconvénients.

L'invention a donc pour objet un dispositif d'actionnement, muni d'au moins un actionneur présentant une pièce actionnée et un organe électrique de commande des déplacements de la pièce actionnée, d'une topologie électronique de pilotage de l'actionneur comprenant un circuit en pont présentant une source continue connectée aux première et deuxième bornes du circuit en pont, l'organe électrique de commande étant connecté entre les troisième et quatrième bornes du circuit en pont, présentant un premier interrupteur connecté entre les première et troisième bornes et un deuxième interrupteur connecté entre les deuxième et quatrième bornes, d'un dispositif de pilotage des interrupteurs et tel que le circuit en pont présente en outre une première diode connectée entre lesdites troisième et deuxième bornes, et dont la cathode est raccordée à ladite troisième borne, une deuxième diode connectée entre lesdites quatrième et troisième bornes, et dont la cathode est raccordée à ladite première borne **caractérisé en ce que** la pièce actionnée est munie d'une partie magnétostrictive soumise au champs magnétique généré par l'organe électrique de commande, et en ce qu'il comprend en outre une capacité connectée entre les troisième et quatrième bornes en parallèle avec l'organe de commande..

L'invention sera mieux comprise et d'autres particularités et avantages apparaîtront à la lecture de la description qui va suivre, la description faisant référence aux dessins annexés parmi lesquels :
- figure 1, une représentation schématique du dispositif d'actionnement et en particulier de sa topologie électronique de pilotage;
- figure 2, une représentation schématique de la structure d'un actionneur du dispositif;
- figure 3, une représentation schématique de la structure d'un actionneur du dispositif selon une variante qui ne constitue pas un mode de réalisation;
- figure 4, un diagramme représentant un mouvement souhaité de l'actionneur appliqué à un injecteur d'essence;
- figure 5, les chronogrammes de différents signaux et mouvements durant le mouvement de l'actionneur représenté à la figure 4;
- figure 6, un diagramme représentant un autre mouvement d'une partie actionnée de l'actionneur qui est susceptible d'être générée;
- figure 7,une représentation schématique d'une variante du dispositif d'actionnement comprenant plusieurs actionneurs;
- figure 8, un mode de réalisation de la topologie électronique de pilotage adaptée à un organe électrique de commande magnétostrictif;
- figure 9, un mode de réalisation de la topologie électronique de pilotage comprenant une diode montée en série avec l'organe électrique de commande.

L'invention propose un dispositif d'actionnement présentant une topologie électronique de pilotage d'un actionneur à la structure et au pilotage simplifié. Deux diodes en antiparallèle sont utilisées dans un circuit en pont en remplacement d'interrupteurs utilisés dans l'état de la technique.

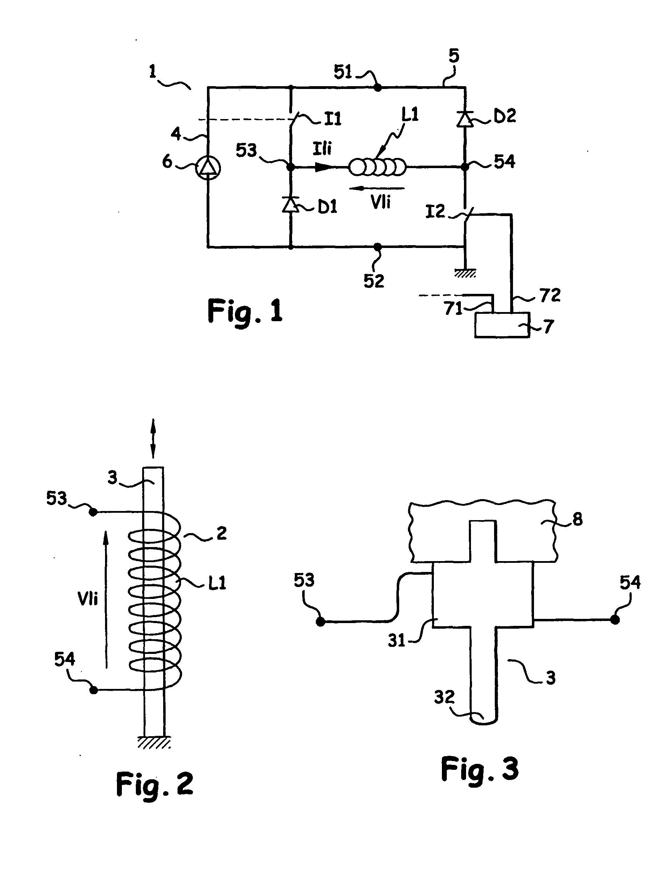

La figure 1 représente schématiquement un dispositif d'actionnement 1. Ce dispositif d'actionnement 1 est muni d'un actionneur non représenté, d'une topologie électronique de pilotage 4 et d'un dispositif de pilotage des interrupteurs 7.

L'actionneur comprend une pièce actionnée et un organe électrique de commande des déplacements de la pièce actionnée. La figure 1 montre l'organe électrique de commande L1 sous forme de dipôle.

La topologie électronique de pilotage 4 comprend un circuit en pont 5. Ce circuit en pont 5 comprend de façon connue en soi quatre bornes 51, 52, 53 et 54. Une source électrique continue 6, par exemple une batterie ou un convertisseur de puissance alternatif-continu, est connectée aux premières et deuxièmes bornes 51 et 52 du pont 5 et fournit une tension ou une intensité continue. L'organe électrique de commande L1 est connecté entre les troisième et quatrième bornes du circuit en pont 5. Un premier interrupteur I1 est connecté entre les première et troisième bornes 51 et 53, et un deuxième interrupteur I2 est connecté entre les deuxième et quatrièmes bornes 52 et 54. L'organe électrique de commande L1 peut se présenter sous forme de circuit intégré dans lequel sont ménagés des transistors de type Mos utilisés comme interrupteurs I1 et I2. On peut également utiliser d'autre types d'interrupteurs tels que des transistors IGBT ou des amplis OP. La commutation des interrupteurs I1 et I2 est commandée par l'intermédiaire d'un dispositif de pilotage des interrupteurs 7, par l'intermédiaire de lignes de pilotage 71 et 72. Le circuit en pont présente en outre des première et deuxième diodes D1 et D2. La première diode D1 est connectée entre les troisième et deuxième bornes 51 et 54, la cathode de la diode D1 étant raccordée à la troisième borne 51. La deuxième diode est connectée entre les quatrième et première bornes 52 et 53, la cathode de la deuxième diode D2 étant connectée à la première borne.

L'utilisation des diodes D1 et D2 simplifie la structure du dispositif de pilotage des interrupteurs 7 et le procédé de pilotage des interrupteurs de la topologie électronique de pilotage de l'actionneur. Un exemple de procédé de pilotage des interrupteurs I1 et I2 sera détaillé par la suite. Les diodes décrites peuvent être de tout type approprié. On utilise de préférence des transistors Mos montés en diode, afin de faciliter l'intégration de la topologie électronique de pilotage et d'en réduire le coût.

La figure 2 illustre une première variante d'un actionneur 2 utilisé dans le dispositif d'actionnement 1. L'actionneur 2 comprend une pièce actionnée 3 munie d'une partie en matériau magnétostrictif. Cette partie magnétostrictive est placée dans le champ magnétique généré par l'organe électrique de commande L1, réalisé sous forme de bobine dans l'exemple. La pièce actionnée 3 est par exemple fixée à une de ses extrémités, l'autre extrémité étant mobile comme illustré par la flèche de la figure 2. Lorsque la partie magnétostrictive est soumise au champ magnétique, cette partie subit des déformations longitudinales cumulées. L'extrémité mobile de la pièce actionnée 3 est alors déplacée longitudinalement en fonction du champ magnétique qui est appliqué. Cette variante permet notamment d'obtenir un déplacement proportionnel au courant traversant l'organe électrique de commande L1, qui est assimilable à une bobine.

La figure 3 illustre une variante d'un actionneur 2 utilisé dans le dispositif d'actionnement 1, qui ne constitue pas un mode de réalisation. L'actionneur 2 comprend une pièce actionnée 3 présentant une portion piézostrictive 31 connectée aux bornes 53 et 54. En pratique, la portion piézostrictive est connectée en série avec une bobine entre les bornes 53 et 54. La pièce actionnée 3 présente une extrémité encastrée par exemple dans un carter 8. La pièce actionnée 3 présente en outre une autre extrémité mobile 32. La tension ou l'intensité appliquée sur les bornes 53 et 54 induit une déformation longitudinale de la portion piézostrictive 31. La partie piézostrictive subit des déformations longitudinales cumulées. L'extrémité mobile 32 de la pièce actionnée 3 est alors déplacée longitudinalement en fonction de la tension ou du courant qui est appliqué.

On peut former la portion piézostrictive 31 par un empilement de fines couches de céramiques de sorte que les polarisations successives soient alternées.

On peut prévoir dans les deux variantes que l'actionneur comprend un corps fixe 8 et que la pièce actionnée ou la portion mobile est montée coulissante par rapport au corps fixe 8. On peut notamment prévoir que le corps est un corps d'injecteur automobile muni d'un conduit de passage d'essence obturé par une aiguille solidaire en coulissement de la pièce actionnée 3, de façon connue en soi. On peut notamment prévoir que l'aiguille repose sur un siège du corps de l'injecteur en position de blocage de l'injection d'essence, pour ainsi former un clapet.

L'organe électrique de commande L1 et la pièce actionnée sont de préférence configurés pour que le déplacement de la pièce actionnée 3, ou en l'occurrence de son extrémité mobile, soit proportionnel à l'amplitude du signal appliqué aux bornes de l'organe électrique de commande L1. Du fait de l'inertie habituellement constatée dans la pièce actionnée 3, le signal appliqué et le déplacement de la pièce actionnée peuvent être déphasés.

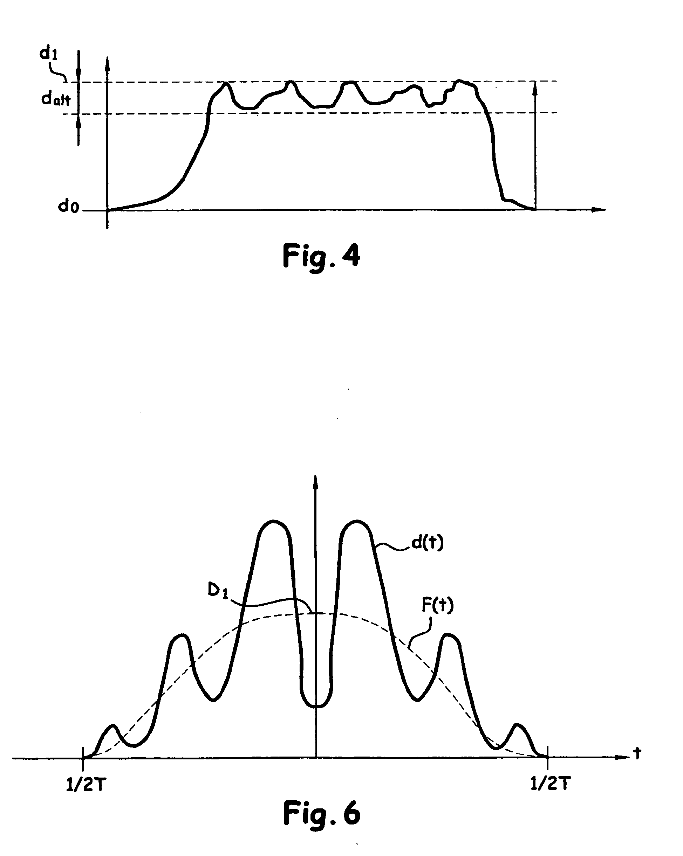

Dans son application à un injecteur automobile, on souhaite réaliser une séquence de pilotage de l'actionneur telle que représentée à la figure 4. Ce diagramme présente la position de l'extrémité de l'actionneur, par exemple de l'aiguille de l'injecteur, en fonction du temps. L'aiguille est ainsi déplacée initialement d'une première position de consigne d0 jusqu'à une deuxième position de consigne d1, avec une amplitude valant d1-d0. L'aiguille se déplace alors alternativement d'une distance dalt par rapport à la deuxième position de consigne d1. Dalt présente une amplitude inférieure à d1-d0. Le déplacement alternatif de la distance dalt est généralement périodique. L'aiguille peut ultérieurement être ramenée à la première position de consigne d0 ou être maintenue à la position de consigne d1. On peut également prévoir que le déplacement alternatif ne suive pas immédiatement le déplacement vers la deuxième position de consigne, et que l'aiguille soit maintenue à la position de consigne pendant une certaine durée.

Cette séquence peut par exemple correspondre soit à une séquence d'injection, soit à une séquence préalable à l'injection, comme cela a été décrit dans les documents de l'état de la technique. On peut notamment prévoir que la deuxième position de consigne soit une position d'ouverture de l'aiguille dans le cas où le déplacement alternatif est utilisé pendant l'injection. On peut également prévoir que la deuxième position de consigne soit une position de fermeture de l'aiguille, et que le déplacement alternatif par rapport à cette position est généré juste avant l'ouverture de l'aiguille. Les deux phases d'injection présentant des déplacements alternatifs peuvent bien entendu être combinées.

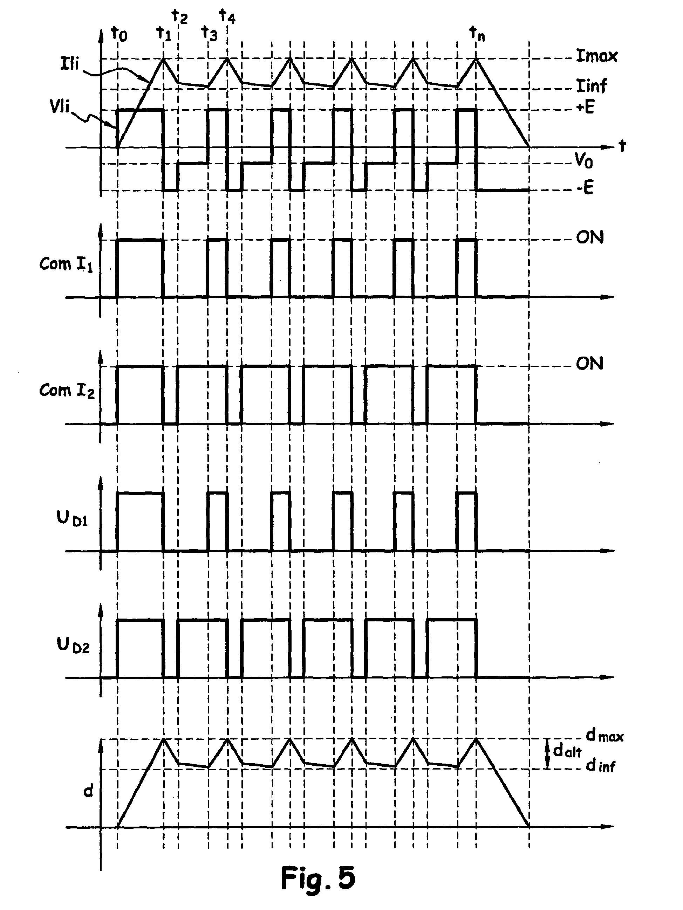

La figure 5 représente les chronogrammes de différents signaux de pilotage appliqués par le dispositif de pilotage des interrupteurs 7, des signaux appliqués aux bornes de l'organe électrique de commande L1, et du déplacement de l'aiguille, dans le cas d'un actionneur magnétostrictif. L'organe électrique de commande L1 est alors assimilé électriquement à une inductance. La source électrique continue 6 est dans l'exemple une source de tension continue appliquant un potentiel E.

Dans l'exemple représenté, le niveau de tension appliqué sur la grille de transistors formant les interrupteurs I1 et I2 correspond à leur position de commutation, comme cela est illustré à la figure 5.

Pendant la phase t0-t1, les interrupteurs I1 et I2 sont fermés alors que l'aiguille est à la position de consigne d0. Les diodes D1 et D2 sont alors bloquées, et le courant emprunte le chemin suivant entre les bornes 51 et 52: 51-53-54-52. Ces nombres correspondent aux références des bornes traversées successivement. La tension Vli entre les bornes 53 et 54 est alors sensiblement égale à E. L'organe électrique de commande L1 est alors traversé par un courant Ili croissant et sensiblement proportionnel au déplacement d de l'aiguille. L'aiguille est alors déplacée de la position de consigne d0 jusqu'à la position de consigne d1.

Pendant la phase t1-t2, les interrupteurs I1 et I2 sont ouverts, alors que les diodes D1 et D2 deviennent passantes. Le courant emprunte alors le chemin suivant entre les bornes 51 et 52: 52-53-54-51. La tension Vli entre les bornes 53 et 54 est alors sensiblement égale à -E, aux tensions de seuil des diodes D1 et D2 près. L'organe électrique de commande L1 est alors traversé par un courant Ili décroissant et sensiblement proportionnel au déplacement de l'aiguille. L'aiguille est alors déplacée d'une distance inférieure à dalt en direction de la position de consigne d0.

Pendant la phase t2-t3, l'interrupteur I1 est ouvert et l'interrupteur I2 est fermé. La diode D2 est bloquée, tandis que la diode D1 est passante. Le courant traversant l'organe électrique de commande L1 effectue un court-circuit entre les bornes 53, 54 et 52. L'inductance restitue alors l'énergie emmagasinée durant les phases précédentes. La tension Vli entre les bornes 53 et 54 est alors sensiblement égale à -V0, ce qui correspond à la tension de seuil de la diode D1. L'organe électrique de commande L1 est alors traversé par un courant Ili décroissant plus lentement que lors de la phase t1-t2. On génère durant cette phase un déplacement plus lent de l'aiguille jusqu'à la position d1-dalt.

Il faut noter que les phases t1-t2 et t2-t3 peuvent être interverties ou qu'une seule de ces phases peut être utilisée comme phase de décroissance de l'intensité, entre deux phases de croissance, en fonction des besoins.

Durant la phase t3-t4, l'interrupteur I1 est fermé et l'interrupteur I2 est fermé, comme durant la phase t0-t1. Les diodes D1 et D2 sont bloquées. On déplace alors l'aiguille jusqu'à la position de consigne d1. Du fait que le déplacement de cette phase est inférieur au déplacement de la phase t0-t1, cette phase est également plus courte que la phase t0-t1. On peut cependant envisager d'appliquer une tension moyenne différente de E durant la phase t2-t3 afin de modifier la pente de la courbe d'intensité durant cette phase.

Les alternances des phases t1-t2, t2-t3 et t3-t4 sont répétées plusieurs fois, généralement de façon périodique, lorsque l'aiguille est proche de sa position de consigne d1, jusqu'à l'instant tn, comme représenté à la figure 5. L'aiguille est alors déplacée jusqu'à sa position de consigne d0, en ouvrant les interrupteurs I1 et I2 pendant une durée adéquate.

Dans une application de l'actionneur à un injecteur de moteur thermique, on peut prévoir que le cycle soit répété à une fréquence de plusieurs dizaines de hertz en fonction du régime moteur. Les phases de déplacement depuis la position de consigne d1 sont répétées à une fréquence plusieurs fois supérieure à la fréquence du cycle complet.

On peut utiliser une tension E de 12V, une inductance de l'organe électrique de commande L1 de quelques µH à plusieurs mH.

On peut également générer un déplacement de l'aiguille ou de l'extrémité mobile de la partie actionnée 3, tel que représenté sur la figure 6. D(t) représente ce déplacement. Ce déplacement peut être généré par le dispositif de pilotage des interrupteurs 7 de façon à appliquer un signal de tension ou d'intensité de profil similaire sur les bornes de l'organe électrique de commande L1. D(t) peut être exprimé de la façon suivante:
D(t)= F(t)*G(t) + F(t), avec F(t) correspondant à la valeur moyenne du signal électrique pendant un temps d'application du signal T, le signal F(t) étant modulé par une excitation G(t) de la forme G(t)=G * sin (Wt*t). On peut prévoir que la pulsation Wt dépende du temps durant la période d'excitation T.

F(t) prend donc typiquement la forme:
F(t)=D1*(1+cos(2*π*t/T)) avec |t|<T/2 et F(t)=0 pour |t|>T/2.

On peut également prévoir de définir D(t) par une fonction linéaire ou polynomiale définie par morceaux dans l'intervalle de temps d'excitation T.

On peut utiliser tout dispositif approprié de pilotage des interrupteurs. On peut notamment utiliser un dispositif de pilotage présentant un organe de mesure du signal appliqué aux bornes de l'organe électrique de commande L1. Le dispositif de pilotage peut comparer ce signal à un seuil haut et un seuil bas, pour commuter les différents interrupteurs de la topologie électronique. On peut par exemple prévoir qu'à la fin de la phase t0-t1, on détecte que l'actionneur a atteint la position d1. Le dispositif de pilotage ouvre alors les interrupteurs I1 et 12 dans l'exemple de la figure 1. De façon similaire, à la fin de la phase t2-t3, on détecte que l'actionneur a atteint la position d1-dalt. Le dispositif de pilotage ferme alors l'interrupteur I2.

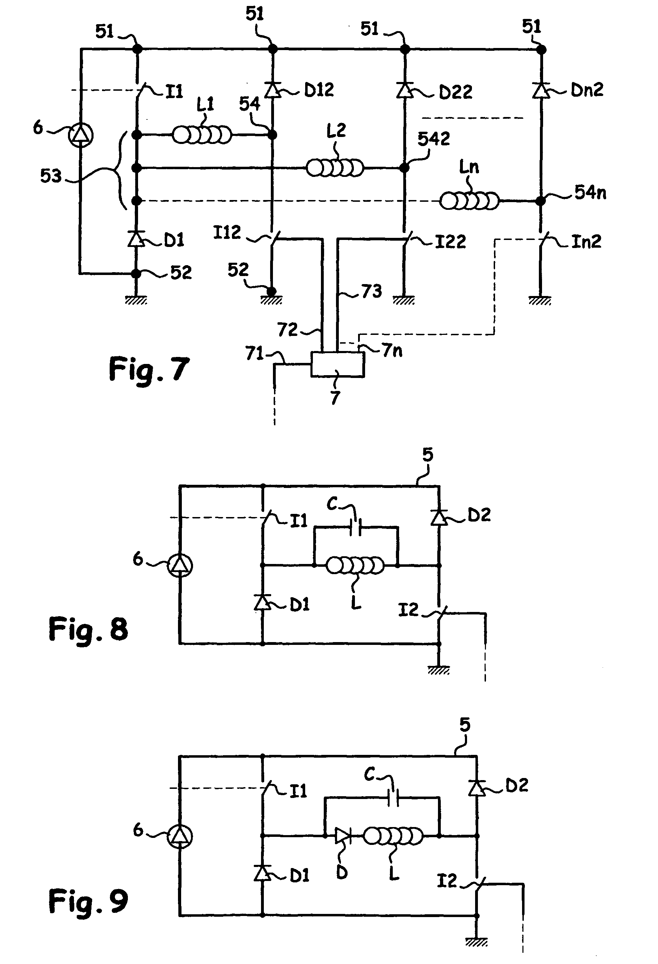

La figure 7 représente un dispositif d'actionnement muni de plusieurs actionneurs. Chaque actionneur présente un organe électrique de commande L. Les organes électriques de commande sont désignés respectivement par L1, L2...Ln. On forme un circuit en pont pour chaque organe électrique de commande L, en gardant une branche commune pour tous les circuits en pont. Le premier circuit en pont est similaire à celui de la figure 1. La borne 52 est une connexion à la masse, représentée par toutes les connexions à la masse de la topologie électronique de pilotage. On peut également envisager une structure similaire pour la borne 51. On ne décrira par la suite que la partie de la topologie électronique associée à un actionneur supplémentaire, celle-ci étant par défaut similaire pour les différents actionneurs.

Un actionneur supplémentaire présente un organe électrique de commande Ln d'une pièce actionnée de l'actionneur supplémentaire. L'organe électrique de commande Ln est connecté entre la troisième borne 53 et une borne supplémentaire 54n. Une diode supplémentaire Dn2 est connectée entre la borne supplémentaire 54n et la première borne 51, la cathode de la diode Dn2 étant raccordée à la borne 51. Un interrupteur supplémentaire In2 est connecté entre la borne supplémentaire 54n et la deuxième borne 52 ou la ligne de masse. On forme ainsi un nouveau circuit en pont présentant une branche commune avec les autres circuits en pont, et présentant une fonction similaire. Ce circuit présente ainsi l'interrupteur I1 et la diode D1 en commun avec les autres circuits en pont.

On constate par une étude rapide que l'actionnement de l'interrupteur I1 pour piloter un des actionneurs ne perturbe pas le fonctionnement des autres actionneurs. En particulier pour des actionneurs d'injection, l'actionnement a lieu à des instants décalés dans le temps, et la réalisation d'une commande d'injection sur un actionneur ne provoque pas une commande d'injection simultanée sur d'autres actionneurs. Durant toutes les étapes où un actionneur est actif, par exemple entre t0 et tn, les interrupteurs In2 des autres actionneurs sont ouverts, et les autres actionneurs restent ainsi inactifs. On simplifie à la fois la topologie électronique de pilotage et la structure du dispositif de pilotage des actionneurs 7. On réduit le nombre de lignes de pilotage 71, 72, 73 ...7n, le nombre d'interrupteurs et le nombre de diodes.

Ce dispositif peut notamment être appliqué à des actionneurs d'injecteurs pour moteurs à multicylindres. Ce dispositif peut notamment comprendre 4 ou 6 actionneurs pilotés par une topologie électronique présentant une portion commune à tous les actionneurs, et une portion spécifique pour chaque actionneur. On utilise une commande adaptée pour décaler dans le temps les différents circuits.

L'invention propose un mode de réalisation de la topologie électronique de pilotage pour les actionneurs magnétostrictifs. Cette variante est représentée à la figure 8. Un condensateur est placé en parallèle avec l'organe électrique de commande L et connectée entre les troisième et quatrième bornes 53 et 54. Une telle capacité permet d'obtenir une forme proche d'une sinusoïde du signal aux bornes d'un organe électrique de commande L. On limite ainsi les pertes par courant de Foucault dans l'actionneur magnétostrictif. On peut notamment combiner une capacité d'environ 0,1µF en combinaison avec un organe électrique de commande L présentant une inductance équivalente de 1 mH. Cette variante est bien entendu applicable au mode de réalisation représenté à la figure 7, en plaçant la capacité en parallèle de chaque organe électrique de commande L.

Selon un autre représentée à la figure 9, on dispose également une diode montée en série avec l'organe de commande, et dont l'anode est raccordée à la troisième borne. On garantit ainsi qu'un organe électrique de commande L soit parcouru par un courant dans un seul sens lorsqu'on lui applique un signal de tension continue. On évite ainsi des déplacements au-delà de la position de consigne d0.

L'invention n'est bien entendu pas limitée strictement aux exemples décrits ci-dessus, donnés à titre explicatif. On peut notamment prévoir d'intégrer différents composants connus de l'homme de métier dans les différentes branches du circuit en pont, sans pour autant sortir du cadre de l'invention.

## Revendications

1. Dispositif d'actionnement (1), muni:
- d'au moins un actionneur (2) présentant une pièce actionnée (3) et un organe électrique de commande (L1) des déplacements de la pièce actionnée;
- d'une topologie électronique de pilotage (4) de l'actionneur comprenant un circuit en pont (5):
- présentant une source continue (6) connectée aux première et deuxième bornes (51,52) du circuit en pont;
- l'organe électrique de commande étant connecté entre les troisième et quatrième bornes (53,54) du circuit en pont;
- présentant un premier interrupteur (I1) connecté entre les première et troisième bornes et un deuxième interrupteur (12) connecté entre les deuxième et quatrième bornes;
- présentant une première diode (D1) connectée entre lesdites troisième et deuxième bornes, et dont la cathode est raccordée à ladite troisième borne;
- présentant une deuxième diode (D2) connectée entre lesdites quatrième et première bornes, et dont la cathode est raccordée à ladite première borne;
- d'un dispositif de pilotage (7) des interrupteurs;
- **caractérisé en ce que :**
- la pièce actionnée (3) est munie d'une partie magnétostrictive soumise au champs magnétique généré par l'organe électrique de commande;
- il comprend en outre une capacité connectée entre les troisième et quatrième bornes en parallèle avec l'organe de commande (7).

2. Dispositif d'actionnement selon la revendication 1, **caractérisé en ce que** l'actionneur est conformé pour que les déplacements de la pièce actionnée (3) soient sensiblement proportionnels à l'amplitude du signal appliqué aux bornes de l'organe électrique de commande.

3. Dispositif d'actionnement selon la revendication 1 ou 2, **caractérisé en ce que** l'actionneur comprend un corps fixe (8), et **en ce que** la pièce actionnée est montée coulissante par rapport au corps fixe.

4. Dispositif d'actionnement selon la revendication 3, **caractérisé en ce que** le corps est un corps d'injecteur automobile muni d'un conduit obturé sélectivement par une aiguille solidaire en coulissement de la pièce actionnée.

5. Dispositif d'actionnement selon la revendication 4, **caractérisé en ce que** le dispositif de pilotage (7) des interrupteurs est susceptible de générer un signal de pilotage des premiers et deuxièmes interrupteurs, de sorte que l'aiguille soit déplacée d'une première amplitude jusqu'à une position de consigne, et de sorte que l'aiguille se déplace alternativement par rapport à la position de consigne avec une deuxième amplitude inférieure à la première.

6. Dispositif d'actionnement selon l'une quelconque des revendications précédentes, **caractérisé en ce que** la deuxième borne du circuit en pont est connectée à une ligne de masse, et **en ce que** :
- ce dispositif d'actionnement comprend en outre au moins un autre actionneur supplémentaire, chaque actionneur supplémentaire présentant une pièce actionnée et un organe électrique de commande (L2..Ln) des déplacements de sa pièce actionnée;
- la topologie électronique de pilotage (4) de l'actionneur comprend un interrupteur supplémentaire (I22..In2), une diode supplémentaire (D22..Dn2) et une borne supplémentaire (542..54n) pour chaque actionneur supplémentaire,
- la diode supplémentaire est connectée entre ladite première borne et la borne supplémentaire et sa cathode est raccordée à ladite première borne;
- l'organe électrique de commande de l'actionneur supplémentaire est connecté entre la troisième borne et la borne supplémentaire;
- l'interrupteur supplémentaire est connecté entre la borne supplémentaire et la ligne de masse.

7. Dispositif selon l'une quelconque des revendications précédentes, **caractérisé en ce qu'**il comprend en outre une troisième diode montée en série avec l'organe de commande et dont l'anode est raccordée à la troisième borne.

## Claims

1. Actuation device (1), provided:
- with at least one actuator (2) having an actuated part (3) and an electrical control member (L1) for controlling the movements of the actuated part;
- with an electronic control topology (4) for the actuator comprising a bridge circuit (5):
- having a DC source (6) connected to the first and second terminals (51, 52) of the bridge circuit;
- the electrical control member being connected between the third and fourth terminals (53, 54) of the bridge circuit;
- having a first switch (I1) connected between the first and third terminals and a second switch (12) connected between the second and fourth terminals;
- having a first diode (D1) connected between said third and second terminals, and the cathode of which is connected to said third terminal;
- having a second diode (D2) connected between said fourth and first terminals, and the cathode of which is connected to said first terminal;
- with a device (7) for controlling the switches;
- **characterized in that**:
- the actuated part (3) is provided with a magnetostrictive part subjected to the magnetic field generated by the electrical control member;
- it also comprises a capacitor connected between the third and fourth terminals in parallel with the control member (7).

2. Actuation device according to Claim 1, **characterized in that** the actuator is configured so that the movements of the actuated part (3) are substantially proportional to the amplitude of the signal applied to the terminals of the electrical control member.

3. Actuation device according to Claim 1 or 2, **characterized in that** the actuator comprises a fixed body (8), and **in that** the actuated part is mounted to slide relative to the fixed body.

4. Actuation device according to Claim 3, **characterized in that** the body is a motor vehicle injector body provided with a duct blocked selectively by a needle that slides together with the actuated part.

5. Actuation device according to Claim 4, **characterized in that** the device (7) for controlling the switches is liable to generate a control signal for the first and second switches, so that the needle is moved by a first amplitude to a setpoint position, and so that the needle is moved alternately relative to the setpoint position with a second amplitude which is less than the first.

6. Actuation device according to any one of the preceding claims, **characterized in that** the second terminal of the bridge circuit is connected to a ground line, and **in that**:
- this actuation device also comprises at least one other additional actuator, each additional actuator having an actuated part and an electrical control member (L2...Ln) controlling the movements of its actuated part;
- the electronic control topology (4) of the actuator comprises an additional switch (I22...In2), an additional diode (D22...Dn2) and an additional terminal (542...54n) for each additional actuator,
- the additional diode is connected between said first terminal and the additional terminal and its cathode is connected to said first terminal;
- the electrical control member for the additional actuator is connected between the third terminal and the additional terminal;
- the additional switch is connected between the additional terminal and the ground line.

7. Device according to any one of the preceding claims, **characterized in that** it also comprises a third diode mounted in series with the control member and the anode of which is connected to the third terminal.

## Patentansprüche

1. Betätigungsvorrichtung (1), die versehen ist mit:
- mindestens einem Stellglied (2), das ein betätigtes Bauteil (3) und ein elektrisches Organ (L1) zur Steuerung der Verschiebungen des betätigten Bauteils aufweist;
- einer elektronischen Topologie (4) zum Steuern des Stellglieds, die eine Brückenschaltung (5) enthält:
- die eine Gleichspannungsquelle (6) aufweist, welche mit der ersten und der zweiten Klemme (51, 52) der Brückenschaltung verbunden ist;
- wobei das elektrische Steuerorgan zwischen der dritten und der vierten Klemme (53, 54) der Brückenschaltung verbunden ist;
- die einen ersten Unterbrecher (I1), der zwischen der ersten und der zweiten Klemme verbunden ist, und einen zweiten Unterbrecher (12) aufweist, der zwischen der zweiten und der vierten Klemme verbunden ist;
- die eine erste Diode (D1) aufweist, die zwischen der dritten und der zweiten Klemme verbunden ist und deren Kathode an die dritte Klemme angeschlossen ist;
- die eine zweite Diode (D2) aufweist, die zwischen der vierten und der ersten Klemme verbunden ist und deren Kathode an die erste Klemme angeschlossen ist;
- einer Steuervorrichtung (7) der Unterbrecher;
**dadurch gekennzeichnet, dass:**
- das betätigte Bauteil (3) mit einem magnetostriktiven Teil versehen ist, der dem vom elektrischen Steuerorgan erzeugten Magnetfeld ausgesetzt ist,
- sie außerdem einen zwischen der dritten und der vierten Klemme parallel mit dem Steuerorgan (7) verbundenen Kondensator aufweist.

2. Betätigungsvorrichtung nach Anspruch 1, **dadurch gekennzeichnet, dass** das Stellglied so gestaltet ist, dass die Verschiebungen des betätigten Bauteils (3) im Wesentlichen proportional zur Amplitude des Signals sind, das an die Klemmen des elektrischen Steuerorgans angelegt wird.

3. Betätigungsvorrichtung nach Anspruch 1 oder 2, **dadurch gekennzeichnet, dass** das Stellglied einen ortsfesten Körper (8) aufweist, und dass das betätigte Bauteil bezüglich dieses ortsfesten Körpers gleitend montiert ist.

4. Betätigungsvorrichtung nach Anspruch 3, **dadurch gekennzeichnet, dass** der Körper ein Körper einer Kraftfahrzeug-Einspritzdüse ist, die mit einem Kanal versehen ist, der selektiv von einer Nadel verschlossen wird, die verschiebefest mit dem betätigten Bauteil verbunden ist.

5. Betätigungsvorrichtung nach Anspruch 4, **dadurch gekennzeichnet, dass** die Steuervorrichtung (7) der Unterbrecher ein Steuersignal der ersten und zweiten Unterbrecher erzeugen kann, damit die Nadel um eine ersten Amplitude bis zu einer Sollstellung verschoben wird, und damit die Nadel sich abwechselnd bezüglich der Sollstellung mit einer zweiten Amplitude geringer als die erste verschiebt.

6. Betätigungsvorrichtung nach einem der vorhergehenden Ansprüche, **dadurch gekennzeichnet, dass** die zweite Klemme der Brückenschaltung mit einer Masseleitung verbunden ist, und dass:
- diese Betätigungsvorrichtung außerdem mindestens ein weiteres zusätzliches Stellglied aufweist, wobei jedes zusätzliche Stellglied ein betätigtes Bauteil und ein elektrisches Steuerorgan (L2 ... Ln) der Verschiebungen seines betätigten Bauteils aufweist;
- die elektronische Steuertopologie (4) des Stellglieds einen zusätzlichen Unterbrecher (I22 ... In2), eine zusätzliche Diode (D22 ... Dn2) und eine zusätzliche Klemme (542 ... 54n) für jedes zusätzliche Stellglied enthält,
- die zusätzliche Diode zwischen der ersten Klemme und der zusätzlichen Klemme verbunden ist und ihre Kathode an die erste Klemme angeschlossen ist;
- das elektrische Steuerorgan des zusätzlichen Stellglieds zwischen der dritten Klemme und der zusätzlichen Klemme verbunden ist;
- der zusätzliche Unterbrecher zwischen der zusätzlichen Klemme und der Masseleitung verbunden ist.

7. Vorrichtung nach einem der vorhergehenden Ansprüche, **dadurch gekennzeichnet, dass** sie außerdem eine dritte Diode aufweist, die in Reihe mit dem Steuerorgan eingebaut und deren Anode an die dritte Klemme angeschlossen ist.
